(19)

Europäisches
Patentamt
European
Patent Office
Office européen
des brevets

(11) **EP 4 654 475 A1**

(12) **EUROPEAN PATENT APPLICATION**
published in accordance with Art. 153(4) EPC

(43) Date of publication:
**26.11.2025 Bulletin 2025/48**

(21) Application number: **23916884.2**

(22) Date of filing: **23.02.2023**

(51) International Patent Classification (IPC):
***H03H 9/145*** (2006.01)

(86) International application number:
**PCT/CN2023/077977**

(87) International publication number:
**WO 2024/152407 (25.07.2024 Gazette 2024/30)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **18.01.2023 CN 202310120451**

(71) Applicant: **Zhejiang Starshine Semiconductor
Co., Ltd.
City Wenzhou, Zhejiang 325024 (CN)**

(72) Inventors:
• **GAO, Anming
Wenzhou, Zhejiang 325024 (CN)**
• **JIANG, Wei
Wenzhou, Zhejiang 325024 (CN)**

(74) Representative: **J A Kemp LLP
80 Turnmill Street
London EC1M 5QU (GB)**

(54) **INTERDIGITAL TRANSDUCER AND RESONATOR**

(57) The present application provides an interdigital transducer and a resonator. The interdigital transducer includes a piezoelectric substrate and a functional layer arranged on a surface of the piezoelectric substrate. The functional layer includes a first interdigital electrode and a second interdigital electrode. The first interdigital electrode includes a first bus bar and a plurality of first electrode fingers. The second interdigital electrode includes a second bus bar and a plurality of second electrode fingers. The first bus bar and the second bus bar are arranged at intervals along a first direction. The first electrode fingers are arranged on one side of the first bus bar close to the second bus bar, and one second electrode finger is arranged between two adjacent first electrode fingers. The first bus bar is provided with a first groove, and in the first direction, each second electrode finger is arranged in correspondence to the first groove. The second bus bar is provided with a second groove, and in the first direction, each first electrode finger is arranged in correspondence to the second groove. The present application can reduce the possibility of the occurrence of scattering phenomenon and spurious modes of the surface acoustic wave in the interdigital transducer, and increase the quality factor of the surface acoustic wave.

FIG. 1

EP 4 654 475 A1

**Description**

This application claims priority to Chinese Patent Application No. 202310120451.8, filed with the China National Intellectual Property Administration on January 18, 2023, and entitled "INTERDIGITAL TRANSDUCER AND RESONATOR", which is hereby incorporated by reference in its entirety.

**TECHNICAL FIELD**

The present application relates to the field of surface acoustic waves, and more specifically, to an interdigital transducer and a resonator.

**BACKGROUND**

A surface acoustic wave filter is a common electronic component, which is widely used in electronic circuit, wireless communication and other systems, and can filter out unnecessary signals and noise to improve the quality of signal reception. Where, the surface acoustic wave (abbreviated as SAW) resonator is a basic unit structure of the surface acoustic wave filter. A plurality of surface acoustic wave resonators are electrically connected to form a surface acoustic wave filter, which can realize the mutual conversion between the acoustic wave and an electrical signal.

An interdigital transducer is an important component of surface acoustic wave resonator. When the surface acoustic wave propagates in the interdigital transducer, the interdigital transducer can realize the mutual conversion between the surface acoustic wave and the electrical signal. However, the interdigital transducer is prone to issues such as surface acoustic wave scattering, unnecessary spurious mode, low quality factor, all of which affect the electrical performance of the resonator and the filter.

**SUMMARY**

The purpose of the present application is to provide an interdigital transducer and a resonator to reduce the possibility of the occurrence of scattering phenomenon and spurious modes of the surface acoustic wave in the interdigital transducer, and increase the quality factor of the surface acoustic wave.

In a first aspect, the present application discloses an interdigital transducer, including a piezoelectric substrate, and a functional layer arranged on a surface of the piezoelectric substrate;

the functional layer includes a first interdigital electrode and a second interdigital electrode, the first interdigital electrode includes a first bus bar and a plurality of first electrode fingers arranged at intervals on the first bus bar, and the second interdigital electrode includes a second bus bar and a plurality of second electrode fingers arranged at intervals on the second bus bar;

the first bus bar and the second bus bar are arranged at intervals along a first direction, and both the first bus bar and the second bus bar extend along a second direction; the first electrode fingers are arranged on a side of the first bus bar close to the second bus bar, and one second electrode finger is accommodated between two adjacent first electrode fingers; and the second electrode fingers are arranged on a side of the second bus bar close to the first bus bar, and one first electrode finger is accommodated between two adjacent second electrode fingers;

the first bus bar is provided with a first groove, and in the first direction, each of the second electrode fingers is arranged in correspondence to the first groove; and the second bus bar is provided with a second groove, and in the first direction, each of the first electrode fingers is arranged in correspondence to the second groove.

Based on the above technical content, during the transmission of surface acoustic wave between the first interdigital electrode and the second interdigital electrode, the surface acoustic wave propagates along the first direction towards a direction away from the second bus bar when the surface acoustic wave is transmitted to an area between the first electrode finger and the second bus bar; and the surface acoustic wave propagates along the first direction towards a direction away from the first bus bar when the surface acoustic wave is transmitted to an area between the second electrode finger and the first bus bar. By providing the first bus bar with the first groove and providing the second bus bar with the second groove, a certain interception effect on the surface acoustic wave can be achieved through the first groove and the second groove, so as to reduce the possibility of the surface acoustic wave escaping through the first bus bar and the second bus bar, thereby reducing the possibility of the occurrence of scattering phenomenon and spurious modes of the surface acoustic wave in the interdigital transducer, and increasing the quality factor of the surface acoustic wave.

In a possible implementation, a plurality of the first grooves are provided, and the plurality of the first grooves are arranged along the second direction, with a part of the plurality of the first grooves being arranged in correspondence to the second electrode fingers respectively;

a plurality of the second grooves are provided, and the plurality of the second grooves are arranged along the second direction, with a part of the plurality of the second grooves being arranged in correspondence to the first electrode fingers respectively.

In a possible implementation, a quantity of the first grooves is equal to a quantity of the second electrode fingers, and each first groove is arranged in a one-to-one correspondence with each second electrode finger;
a quantity of the second grooves is equal to a quantity of the first electrode fingers, and each second groove is arranged in a one-to-one correspondence with each first electrode finger.

By arranging the plurality of first grooves and the plurality of second grooves, and making each of the first grooves correspond to one of the second electrode fingers, and each of the second grooves correspond to one of the first electrode fingers, the area occupied by the first grooves in the first bus bar can be reduced, and the area occupied by the second grooves in the second bus bar can be reduced, thereby reducing the resistance of the first bus bar and the resistance of the second bus bar, and improving the use effect of the interdigital transducer.

In a possible implementation, along the second direction, a length of the first groove is greater than or equal to a width of the second electrode finger, and a length of the second groove is greater than or equal to a width of the first electrode finger.

By making the length of the first groove greater than or equal to the width of the second electrode finger, and the length of the second groove greater than or equal to the width of the first electrode finger, the interception effect of the first groove and the second groove on the surface acoustic wave can be ensured, reducing the possibility of scattering phenomenon of the surface acoustic wave in the interdigital transducer.

In a possible implementation, taking a plane parallel to the piezoelectric substrate as a cross section, a shape of the cross section of each of the first grooves is one of circular shape, elliptical shape, polygonal shape or irregular shape, and the shape of the cross section of each of the second grooves is set to be one of circular shape, elliptical shape, polygonal shape and irregular shape; where the irregular shape is configured to be formed by at least one straight line and at least one curve through enclosure.

In a possible implementation, taking the plane parallel to the piezoelectric substrate as the cross section, the shape of the cross section of the first groove is the circular shape, and the shape of the cross section of the second groove is the circular shape.

In a possible implementation, taking the plane parallel to the piezoelectric substrate as the cross section, the shape of the cross section of the first groove is set to be the ellipse shape, and a major axis of the first groove is parallel to the first direction, or the major axis of the first groove is parallel to the second direction;
the shape of the cross section of the second groove is set to be the ellipse shape, and a major axis of the second groove is parallel to the first direction, or the major axis of the second groove is parallel to the second direction.

In a possible implementation, the major axis of the first groove is parallel to the first direction, and the major axis of the second groove is parallel to the first direction;

a minor axis length of the first groove and a minor axis length of the second groove are both set as $b$, and the minor axis length $b$ is configured as:

$$b \leq \lambda;$$

where, $\lambda$ is set as a wavelength of the surface acoustic wave, $\lambda = 2 \times (W1+W2)$, $W1$ is set as a width of the second electrode finger in the second direction, and $W2$ is set as a distance between the second electrode finger and the adjacent first electrode finger in the second direction.

By setting the minor axis length $b$ to be smaller than the wavelength of the surface acoustic wave, the interception effect of the first groove with the ellipse shape and the second groove with the ellipse shape on the surface acoustic wave can be ensured, thereby reducing the possibility of the occurrence of scattering phenomenon of the surface acoustic wave in the interdigital transducer.

In a possible implementation, among the plurality of first grooves, the shape of the cross section of at least one of the first grooves is set to be same as those of others of the first grooves, or, the shape of the cross section of at least one of the first grooves is set to be different from those of others of the first grooves;
and/or, among the plurality of second grooves, the shape of the cross section of at least one of the second grooves is set to be same as those of others of the second grooves, or, the shape of the cross section of at least one of the second grooves is set to be different from those of others of the second grooves.

In a possible implementation, in a thickness direction of the functional layer, a depth of the first groove is equal to a thickness of the functional layer, and a depth of the second groove is equal to the thickness of the functional layer.

In a possible implementation, in the second direction, a length of the first groove and a length of the second groove are both set as $W$;
the length $W$ of the first groove is configured as: $W1 \leq W < \lambda$; where $W1$ is set as the width of the second electrode finger in the second direction; $\lambda$ is set as the wavelength of the surface acoustic wave, with $\lambda = 2 \times (W1+W2)$, and $W2$ is set as the distance between the second electrode finger and the adjacent first electrode finger in the second direction.

Taking the plurality of first grooves as an example, the length of the first groove is set to $W1 \leq W < \lambda$. When $W < W1$, the length of the first groove is too small, thereby affecting the interception and reflection effect of the first groove on the surface acoustic wave. When $W > \lambda$, it may cause the two adjacent first grooves arranged along the second direction to be communicated with each other, thereby increasing the resistance of the first bus bar and affecting the use effect of the interdigital transducer.

In a possible implementation, the first electrode finger is configured as a square-shaped first electrode finger, and the second electrode finger is configured as a square-shaped second electrode finger.

In a possible implementation, the first electrode finger is configured as a square-shaped first electrode finger, and the second electrode finger is configured as a square-shaped second electrode finger.

In a possible implementation, the square-shaped first electrode finger is provided with at least one first adjustment portion, and the at least one first adjustment portion is arranged along the first direction; the square-shaped second electrode finger is provided with at least one second adjustment portion, and the at least one second adjustment portion is arranged along the first direction.

By arranging the square-shaped first electrode finger with the first adjustment portion and arranging the square-shaped second electrode finger with the second adjustment portion, the acoustic velocity of the surface acoustic wave is adjusted by the first adjustment portion and the second adjustment portion to reduce the possibility of the occurrence of unnecessary spurious mode of the surface acoustic wave.

In a possible implementation, the first adjustment portion is set as an arc-shaped first adjustment portion, a square-shaped first adjustment portion, and an irregular-shaped first adjustment portion; and in a plane where the functional layer is located, the irregular-shaped first adjustment portion is formed by at least one straight line and at least one curve through enclosure;

the second adjustment portion is set as an arc-shaped second adjustment portion, a square-shaped second adjustment portion, and an irregular-shaped second adjustment portion; and in the plane where the functional layer is located, the irregular-shaped second adjustment portion is formed by at least one straight line and at least one curve through enclosure. In a possible implementation, the first adjusting portion is set as the arc-shaped first adjusting portion, and in the square-shaped first electrode finger, the arc-shaped first adjusting portion protrudes toward the second direction;

the second adjusting portion is set as the arc-shaped second adjusting portion, and in the square-shaped second electrode finger, the arc-shaped second adjusting portion protrudes toward the second direction.

In a possible implementation, in each of the square-shaped first electrode fingers, two first adjustment portions are provided, and one of the first adjustment portions is arranged at one end of the square-shaped first electrode finger away from its corresponding first bus bar, and the other first adjustment portion is arranged at one end of the square-shaped first electrode finger close to its corresponding first bus bar;

in each of the square-shaped second electrode fingers, two second adjustment portions are provided, and one of the second adjustment portions is arranged at one end of the square-shaped second electrode finger away from its corresponding second bus bar, and the other second adjustment portion is arranged at one end of the square-shaped second electrode finger close to its corresponding second bus bar.

In a possible implementation, a plurality of the first adjustment portions and a plurality of the second adjustment portions are arranged along the second direction.

In a possible implementation, in the second direction, a width of the first adjustment portion is smaller than the length of the first groove; and a width of the second adjustment portion is smaller than the length of the second groove.

In a possible implementation, a distance between one end of the first electrode finger away from the first bus bar and the second bus bar is less than or equal to $1.5\lambda$; and a distance between one end of the second electrode finger away from the second bus bar and the first bus bar is less than or equal to $1.5\lambda$;

where, $\lambda$ is set as a wavelength of the surface acoustic wave, $\lambda=2\times(W1+W2)$, $W1$ is set as a width of the second electrode finger in the second direction, and $W2$ is set as a distance between the second electrode finger and the adjacent first electrode finger in the second direction.

Taking the first electrode finger as an example, by making the distance between one end of the first electrode finger away from the first bus bar and the second bus bar less than or equal to $1.5\lambda$, the generation of scattering phenomenon of the surface acoustic wave can be suppressed, thereby reducing the possibility of forming a spurious mode.

In a possible implementation, the first bus bar is provided with a plurality of first dummy fingers, and in the first direction, each of the first dummy fingers is arranged to be in correspondence with one of the second electrode fingers;

the second bus bar is provided with a plurality of second dummy fingers, and in the first direction, each of the second dummy fingers is arranged to be in correspondence to one of the first electrode fingers.

In a possible implementation, in the first direction, a distance between each of the first dummy fingers and corresponding second electrode finger is set to be less than or equal to $\lambda$; and a distance between each of the second dummy fingers and corresponding first electrode finger is set to be less than or equal to $\lambda$;

where, $\lambda$ is set as a wavelength of the surface acoustic wave, $\lambda=2\times(W1+W2)$, $W1$ is set as a width of the second electrode finger in the second direction, and $W2$ is set as a distance between the second electrode finger and the adjacent first electrode finger in the second direction.

Taking the first electrode finger as an example, by setting the distance between the first electrode finger and the second dummy finger to be less than or equal to

$\lambda$, the generation of the scattering phenomenon of the surface acoustic wave can be suppressed, thereby reducing the possibility of forming a spurious mode.

In a possible implementation, the piezoelectric substrate is configured as a single-layer piezoelectric substrate, or the piezoelectric substrate is configured as a multi-layer piezoelectric substrate.

In a possible implementation, the piezoelectric substrate is configured as the multi-layer piezoelectric substrate, and the multi-layer piezoelectric substrate includes a base body and a piezoelectric film arranged on a surface of the base body, with the piezoelectric film being connected to the functional layer. In a possible implementation, the base body is made of one of sapphire, spinel, quartz and ceramic;

the piezoelectric film is made of one of lithium tantalate, lithium niobate, aluminum nitride and zinc oxide.

In a possible implementation, the first interdigital electrode is configured as a single-layer first interdigital electrode, or the first interdigital electrode is configured as a multi-layer first interdigital electrode;

the second interdigital electrode is configured as a single-layer second interdigital electrode, or the second interdigital electrode is configured as a multi-layer second interdigital electrode.

In a possible implementation, the first interdigital electrode and the second interdigital electrode are made of one or more of aluminum, copper, gold, silver, chromium, titanium, tungsten and alloy materials.

In a possible implementation, the functional layer further includes two reflective structures, and the two reflective structures are respectively arranged on two ends of the first bus bar along the second direction;

in the first direction, one end of reflective structure is flush with the first bus bar, and the other end of the reflective structure is flush with the second bus bar.

By providing two reflective structures, it is possible to utilize the two reflective structures to exert a certain reflective effect on the surface acoustic wave, thereby reducing the possibility of the surface acoustic wave escaping along the second direction between the first interdigital electrode and the second interdigital electrode.

In a possible implementation, reflective structure is provided with two grooves, and in the second direction, one of the grooves is flush with the first groove, and the other of the grooves is flush with the second groove.

In a possible implementation, the reflective structure is further provided with a plurality of elongated holes, and the plurality of elongated holes are arranged along the second direction, and the elongated holes extend along the first direction.

In a possible implementation, the functional layer is configured as:

forming a functional layer base on the surface of the piezoelectric substrate, and removing a portion of the functional layer base to make the remaining functional layer base form the functional layer.

In a possible implementation, the functional layer is configured as:

covering the surface of the piezoelectric substrate with a shielding layer which is provided with an opening, the opening corresponding to the first interdigital electrode and the second interdigital electrode; and forming the first interdigital electrode and the second interdigital electrode in the opening to make the first interdigital electrode and the second interdigital electrode constitute the functional layer.

In a second aspect, the present application discloses a resonator, including any one of the above-mentioned interdigital transducers.

Since the resonator includes the above-mentioned interdigital transducer, the resonator has all the advantages of the above-mentioned interdigital transducer. For details, please refer to the relevant description above, which will not be repeated here.

In combination with the above technical solutions, the length W of the first groove is configured as: $W1 \leq W < \lambda$, and the length $W$ of the second groove is configured as: $W1 \leq W < \lambda$. During the transmission of surface acoustic wave between the first interdigital electrode and the second interdigital electrode, the surface acoustic wave propagates along the first direction towards a direction away from the second bus bar when the surface acoustic wave is transmitted to an area between the first electrode finger and the second bus bar; and the surface acoustic wave propagates along the first direction towards a direction away from the first bus bar when the surface acoustic wave is transmitted to an area between the second electrode finger and the first bus bar. By providing the first bus bar with the plurality of first grooves arranged along the second direction, and providing the second bus bar with the plurality of second grooves arranged along the second direction, a certain interception effect on the surface acoustic wave can be achieved through the first grooves and the second grooves, so as to reduce the possibility of the surface acoustic wave escaping through the first bus bar and the second bus bar, thereby reducing the possibility of the occurrence of scattering phenomenon and spurious modes of the surface acoustic wave in the interdigital transducer, and increasing the quality factor of the surface acoustic wave.

## BRIEF DESCRIPTION OF DRAWINGS

The drawings herein, which are incorporated into the specification and constitute a part of the present specification, illustrate embodiments consistent with the present application and together with the specification, serve to explain the principles of the present application.

FIG. 1 is a structurally schematic diagram of an interdigital transducer provided by an embodiment of the present application.
FIG. 2 is a cross-sectional view of the interdigital transducer along an A-A line in FIG. 1 provided by an embodiment of the present application.

FIG. 3 is a structurally schematic diagram of an interdigital transducer having a first protrusion and a second protrusion provided by an embodiment of the present application.

FIG. 4 is a structurally schematic diagram of an interdigital transducer having a first dummy finger and a second dummy finger provided by an embodiment of the present application.

FIG. 5 is a structurally schematic diagram of an interdigital transducer provided by an embodiment of the present application, both a first groove and a second groove being configured to be elliptical.

FIG. 6 is a structurally schematic diagram of an interdigital transducer provided by an embodiment of the present application, both a first groove and a second groove being configured to be in various shapes.

FIG. 7 is a simulation schematic diagram of the interdigital transducer in FIG. 1 provided by an embodiment of the present application.

FIG. 8 is a simulation schematic diagram of the interdigital transducer in FIG. 5 provided by an embodiment of the present application.

Explanation of reference signs:

100, piezoelectric substrate; 200, functional layer; 210, first interdigital electrode; 211, first bus bar; 2111, first groove; 212, first electrode finger; 2121, first adjustment portion; 213, first dummy finger; 220, second interdigital electrode; 221, second bus bar; 2211, second groove; 222, second electrode finger; 2221, second adjustment portion; 223, second dummy finger; 230, reflective structure; 231, groove; 232, elongated hole.

Through the above drawings, the specific embodiments of the present application have been shown, and a more detailed description will be provided in the following. These drawings and textual description are not intended to limit the scope of the conception of the present application in any way, but to illustrate the concept of the present application to those skilled in the art with reference to specific embodiments.

## DESCRIPTION OF EMBODIMENTS

As described in the background, the interdigital transducer is an important component of the surface acoustic wave resonator. When the surface acoustic wave propagates in the interdigital transducer, the interdigital transducer can realize the mutual conversion between a surface acoustic wave and an electrical signal. The interdigital transducer includes a first interdigital electrode and a second interdigital electrode that are mutually cooperated with each other. The first interdigital electrode includes a first bus bar and a plurality of first electrode fingers arranged at intervals on the first bus bar;

the second interdigital electrode includes a second bus bar and a plurality of second electrode fingers arranged at intervals on the second bus bar.

When the surface acoustic wave propagates between the first interdigital electrode and the second interdigital electrode, the interdigital transducer can play a certain transducing role on the surface acoustic wave. However, during the transmission of the surface acoustic wave, the surface acoustic wave in the interdigital transducer tends to escape through the first bus bar and the second bus bar, which leads to the occurrence of scattering phenomenon within the interdigital transducer, thereby affecting the quality factor of the surface acoustic wave.

In order to solve the above technical problems, an interdigital transducer is disclosed in the present application. By arranging the first bus bar with a first groove and arranging the second bus bar with a second groove, during the transmission of surface acoustic wave between the first interdigital electrode and the second interdigital electrode, the surface acoustic wave propagates along a first direction towards a direction away from the second bus bar when the surface acoustic wave is transmitted to an area between the first electrode finger and the second bus bar; and the surface acoustic wave propagates along the first direction towards a direction away from the first bus bar when the surface acoustic wave is transmitted to an area between the second electrode finger and the first bus bar. The first groove provided in the first bus bar and the second groove provided in the second bus bar can exert a certain interception effect on the surface acoustic wave, so as to reduce the possibility of the surface acoustic wave escaping through the first bus bar and the second bus bar, thereby reducing the possibility of the occurrence of scattering phenomenon and spurious modes of the surface acoustic wave in the interdigital transducer, and increasing the quality factor of the surface acoustic wave.

Exemplary embodiments will be described in detail herein, with examples thereof shown in the drawings. In the following description, when referring to the drawings, unless otherwise indicated, the same numerals in different drawings denote the same or similar elements. The implementations described in the following exemplary embodiments do not represent all implementations consistent with the present application. Instead, they are merely examples of devices and methods consistent with some aspects of the present application as detailed in the appended claims.

The technical solutions of the present application and how the technical solutions of the present application solve the above-mentioned technical problems are described in detail below with specific embodiments. The following specific embodiments may be combined with each other, and the same or similar concepts or processes may not be repeated in some embodiments. The embodiments of the present application will be described below with reference to the drawings.

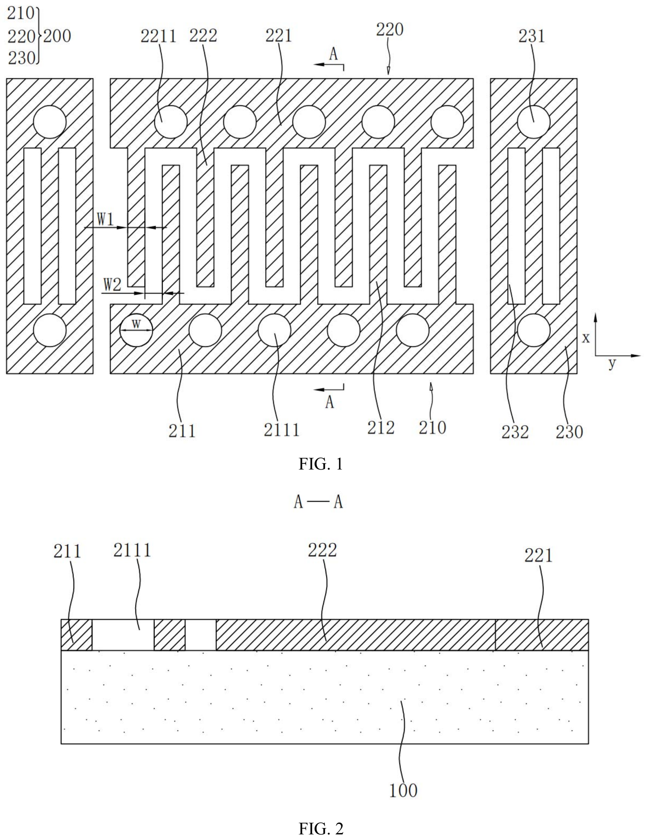

With reference to FIG. 1 and FIG. 2, the present application discloses an interdigital transducer, which may be applied to SAW resonator, temperature compensated SAW resonator (Temperature compensated SAW, abbreviated as TC-SAW) and thin film SAW (Thin Film SAW, abbreviated as TF-SAW), etc. The interdigital transducer includes a piezoelectric substrate 100 and a functional layer 200 arranged on a surface of the piezoelectric substrate 100. The functional layer 200 includes a first interdigital electrode 210 and a second interdigital electrode 220; the first interdigital electrode 210 includes a first bus bar 211 and a plurality of first electrode fingers 212 arranged at intervals on the first bus bar 211; the second interdigital electrode 220 includes a second bus bar 221 and a plurality of second electrode fingers 222 arranged at intervals on the second bus bar 221.

The first bus bar 211 and the second bus bar 221 are arranged at intervals along a first direction (i.e., the x direction in the figure), and the first bus bar 211 and the second bus bar 221 both extend along a second direction (i.e., the y direction in the figure). In an exemplary embodiment, the second direction is perpendicular to the first direction, the first direction may be perpendicular to a length direction of the first bus bar 211, and the second direction may be parallel to the length direction of the first bus bar 211. The first electrode finger 212 is arranged on a side of the first bus bar 211 close to the second bus bar 221, and one second electrode finger 222 is accommodated between two adjacent first electrode fingers 212. The second electrode finger 222 is arranged on a side of the second bus bar 221 close to the first bus bar 211, and one first electrode finger 212 is accommodated between two adjacent second electrode fingers 222.

With reference to FIG. 1 and FIG. 2, the first bus bar 211 is provided with first grooves 2111; and in the first direction, each second electrode finger 222 is arranged in correspondence to the first groove 2111, so as to reduce the possibility of the surface acoustic wave escaping between the second electrode finger 222 and the first bus bar 211 through the first groove 2111. The second bus bar 221 is provided with second grooves 2211, and in the first direction, each first electrode finger 212 is arranged in correspondence to the second groove 2211, so as to reduce the possibility of the surface acoustic wave escaping between the first electrode finger 212 and the second bus bar 221 through the second groove 2211, thereby improving the quality factor (i.e., Q value) of the surface acoustic wave.

Taking the first bus bar 211 as an example, when the surface acoustic wave propagates along the first bus bar 211, its acoustic velocity is relatively low; however, when the surface acoustic wave propagates to the first groove 2111, its acoustic velocity is relatively high, so that a large acoustic velocity difference is generated during the transmission of the surface acoustic wave, causing the surface acoustic wave to be reflected under the action of the first groove 2111 and return to an area between the first interdigital electrode 210 and the second interdigital electrode 220, thereby reducing the possibility of the surface acoustic wave escaping.

In some exemplary embodiments, the piezoelectric substrate 100 is configured as a single-layer piezoelectric substrate 100, or the piezoelectric substrate 100 is configured as a multi-layer piezoelectric substrate 100. Exemplarily, the piezoelectric substrate 100 is configured as a multi-layer piezoelectric substrate 100, and the multi-layer piezoelectric substrate 100 includes a base body and a piezoelectric film arranged on a surface of the base body, and the piezoelectric film is connected to the functional layer 200. Where, the base body may be made of one of sapphire, spinel, quartz and ceramic; and the piezoelectric film is made of one of lithium tantalate (chemical formula $LiTaO_3$), lithium niobate (chemical formula $LiNbO_3$), aluminum nitride (chemical formula AlN) and zinc oxide (chemical formula ZnO).

Exemplarily, in the functional layer 200, the first interdigital electrode 210 and the second interdigital electrode 220 are made of one or more of metal materials such as aluminum (chemical formula Al), copper (chemical formula Cu), gold (chemical formula Au), silver (chemical formula Ag), chromium (chemical formula Cr), titanium (chemical formula Ti), tungsten (chemical formula W), and alloy materials including the above-mentioned metal materials.

The functional layer 200 may be formed on the surface of the piezoelectric substrate 100 by means of a variety of ways. Exemplarily, the functional layer 200 is configured as follows: a single-layer or multi-layer functional layer base may be formed on the surface of the piezoelectric substrate 100 by means of magnetron sputtering, evaporation coating, atomic layer deposition, etc.; then a patterned photoresist is formed on the functional layer base through sequential processes of glue coating, exposure, and development; subsequently, a portion of the functional layer base is removed using methods such as ion beam etching (Ion Beam Etching, abbreviated as IBE) or reactive ion etching (Reactive Ion Etching, abbreviated as RIE) to expose the piezoelectric substrate 100, with the remaining functional layer base forming the functional layer 200; and finally, the photoresist is removed, thereby realizing the formation process of the functional layer 200.

Alternatively, the functional layer 200 is configured as follows: a shielding layer (not shown in the figure) is covered on the surface of the piezoelectric substrate 100, where the shielding layer is provided with openings corresponding to the first interdigital electrode 210 and the second interdigital electrode 220. Exemplarily, the shielding layer may be formed by photoresist through sequential processes of glue coating, exposure, development, etc., and then the first interdigital electrode 210 and the second interdigital electrode 220 are formed at the openings of the shielding layer through an evaporation coating process, so that the first interdigital electrode 210 and the second interdigital electrode 220 constitute the functional layer 200; and finally, the shielding layer is removed through a lift-off process (i.e., lift-off), thereby realizing the formation process of the functional layer 200.

With reference to FIG. 1 to FIG. 5, in some exemplary embodiments, the shape of the first interdigital electrode 210 may be arranged to be identical to the shape of the second interdigital electrode 220. For example, in the first direction, a length of the first electrode finger 212 is equal to a length of the second electrode finger 222; in the second direction, a width of the first electrode finger 212 is equal to a width of the second electrode finger 222.

Exemplarily, $\lambda$ is set as a wavelength of the surface acoustic wave, $\lambda=2\times(W1+W2)$, where *W1* is set as a width of the first electrode finger 212 in the second direction; *W2* is set as a distance in the second direction between the second electrode finger 222 and an adjacent first electrode finger 212. Exemplarily, the first electrode finger 212 is configured as a square-shaped first electrode finger 212, and the second electrode finger 222 is configured as a square-shaped second electrode finger 222.

The distance between one end of the first electrode finger 212 away from the first bus bar 211 and the second bus bar 221 is less than or equal to $1.5\lambda$. The distance between one end of the second electrode finger 222 away from the second bus bar 221 and the first bus bar 211 is less than or equal to $1.5\lambda$. By adopting the above-mentioned technical solutions, taking the first electrode finger 212 as an example, setting the distance between one end of the first electrode finger 212 away from the first bus bar 211 and the second bus bar 221 to be less than or equal to $1.5\lambda$, can suppress the generation of scattering phenomenon of the surface acoustic wave, thereby reducing the possibility of forming a spurious mode.

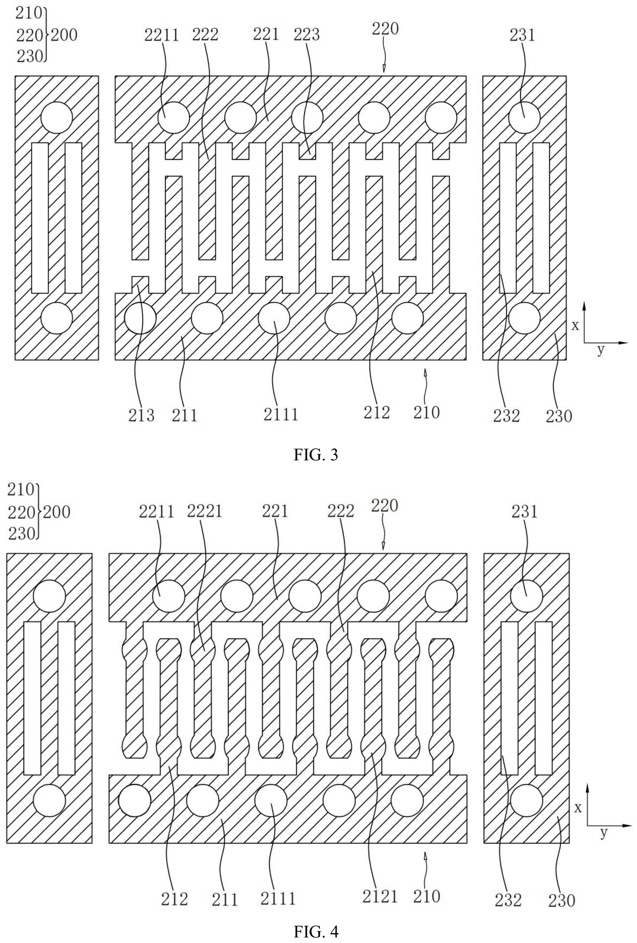

With reference to FIG. 3, in some exemplary embodiments, the first bus bar 211 is provided with a plurality of first dummy fingers 213, and the first dummy fingers 213 extend along the first direction. In the first direction, each first dummy finger 213 is arranged in correspondence to one second electrode finger 222. The second bus bar 221 is provided with a plurality of second dummy fingers 223, and the second dummy fingers 223 extend along the first direction. In the first direction, each second dummy finger 223 is arranged in correspondence to one first electrode finger 212.

Exemplarily, the distance between each first dummy finger 213 and corresponding second electrode finger 222 is set to be less than or equal to $\lambda$. The distance between each second dummy finger 223 and corresponding first electrode finger 212 is set to be less than or equal to $\lambda$. By adopting the above-mentioned technical solutions, taking the first electrode finger 212 as an example, setting the distance between the first electrode finger 212 and the second dummy finger 223 to be less than or equal to $\lambda$ can suppress the generation of scattering phenomenon of the surface acoustic wave, thereby reducing the possibility of forming a spurious mode.

With reference to FIG. 4, the first electrode finger 212 and the second electrode finger 222 may also be configured in other shapes. For example, the square-shaped first electrode finger 212 is provided with at least one first adjustment portion 2121, and the at least one first adjustment portion 2121 is arranged along the first direction; the square-shaped second electrode finger 222 is provided with at least one second adjustment portion 2221, and the at least one second adjustment portion 2221 is arranged along the first direction. Thus, the acoustic velocity of the surface acoustic wave can be adjusted by the first adjustment portion 2121 and the second adjustment portion 2221, thereby reducing the possibility of the occurrence of unnecessary spurious mode of the surface acoustic wave.

Exemplarily, the first adjustment portion 2121 is set as an arc-shaped first adjustment portion 2121, a square-shaped first adjustment portion 2121 and an irregular-shaped first adjustment portion 2121. In the plane where the functional layer 200 is located, the irregular-shaped first adjustment portion 2121 is formed by at least one straight line and at least one curve through enclosure. The second adjustment portion 2221 is set as an arc-shaped second adjustment portion 2221, a square-shaped second adjustment portion 2221 and an irregular-shaped second adjustment portion 2221. In the plane where the functional layer 200 is located, the irregular-shaped second adjustment portion 2221 is formed by at least one straight line and at least one curve through enclosure.

The first adjustment portion 2121 is configured as an arc-shaped first adjustment portion 2121, which protrudes toward the second direction from the square-shaped first electrode finger 212. The second adjustment portion 2221 is configured as an arc-shaped second adjustment portion 2221, which protrudes toward the second direction from the square-shaped second electrode finger 222.

Exemplarily, on each square-shaped first electrode finger 212, two first adjustment portions 2121 are provided. One of the first adjustment portions 2121 is arranged at one end of the square-shaped first electrode finger 212 away from corresponding first bus bar 211, and the other first adjustment portion 2121 is arranged at one end of the square-shaped first electrode finger 212 close to corresponding first bus bar 211.

On each square-shaped second electrode finger 222, two second adjustment portions 2221 are provided. One of the second adjustment portions 2221 is arranged at one end of the square-shaped second electrode finger 222 away from corresponding second bus bar 221, and the other second adjustment portion 2221 is arranged at one end of the square-shaped second electrode finger 222 close to corresponding second bus bar 221. In addition, the plurality of first adjustment portions 2121 and the plurality of second adjustment portions 2221 are arranged along the second direction, thus making the structure of the interdigital transducer more beautiful.

With reference to FIG. 1 to FIG. 5, in some exemplary embodiments, the functional layer 200 also includes two reflective structures 230, which are respectively arranged at both ends of the first bus bar 211 along the second direction. In the first direction, one end of the reflective structure 230 is arranged flush with the first bus bar 211, and the other end of the reflective structure 230 is arranged flush with the second bus bar 221, so that the reflective structure 230 can exert a certain reflective effect on the surface acoustic wave, thereby reducing the possibility of the surface acoustic wave escaping from the area between the first interdigital electrode 210 and the second interdigital electrode 220 along the second direction.

Exemplarily, the reflective structure 230 is provided with two grooves 231. In the second direction, one groove 231 is flush with the first groove 2111, and the other groove 231 is flush with the second groove 2211. The reflective structure 230 is also provided with a plurality of elongated holes 232, which are arranged along the second direction. The elongated hole 232 extends along the first direction.

Furthermore, in the functional layer 200, two reflective structures 230 may be integrally formed with the first interdigital electrode 210 and the second interdigital electrode 220, thereby making the forming process of the reflective structure 230 more convenient.

With reference to FIG. 1 to FIG. 5, in some exemplary embodiments, a plurality of first grooves 2111 are provided. The number of the first grooves 2111 is greater than or equal to the number of the second electrode fingers 222. The plurality of first grooves 2111 are arranged along the second direction, and some of the plurality of first grooves 2111 are arranged in correspondence to respective second electrode fingers 222. A plurality of second grooves 2211 are provided. The number of the second grooves 2211 is greater than or equal to the number of the first electrode fingers 212. The plurality of second grooves 2211 are arranged along the second direction, and some of the plurality of second grooves 2211 are arranged in correspondence to respective first electrode fingers 212.

Exemplarily, the number of the first grooves 2111 is equal to the number of the second electrode fingers 222. Each first groove 2111 is arranged in correspondence to one second electrode finger 222. In the second direction, the length of the first groove 2111 is greater than or equal to the width of the second electrode finger 222, so as to ensure the interception effect of the first groove 2111 on the surface acoustic wave and reduce the possibility of the occurrence of scattering phenomenon of the surface acoustic wave in the interdigital transducer.

With reference to FIG. 1 to FIG. 5, the number of second grooves 2211 is equal to the number of first electrode fingers 212, and each second groove 2211 is arranged in correspondence to one first electrode finger 212. In the second direction, the length of the second groove 2211 is greater than or equal to the width of the first electrode finger 212, so as to ensure the interception effect of the second groove 2211 on the surface acoustic wave and reduce the possibility of the occurrence of scattering phenomenon of the surface acoustic wave in the interdigital transducer.

By arranging the first bus bar 211 with a plurality of first grooves 2111 and arranging the second bus bar 221 with a plurality of second grooves 2211, and making each first groove 2111 correspond to one second electrode finger 222, and each second groove 2211 correspond to one first electrode finger 212, the area occupied by the first grooves 2111 in the first bus bar 211 can be reduced, and the area occupied by the second grooves 2211 in the second bus bar 221 can be reduced, thereby reducing the resistance of the first bus bar 211 and the resistance of the second bus bar 221, and improving the use effect of the interdigital transducer.

With reference to FIG. 1 to FIG. 6, exemplarily, in the second direction, the length of the first groove 2111 and the length of the second groove 2211 are both set as W; and the length W of the first groove 2111 is configured as: $W1 \leq W < \lambda$. Taking the plurality of first grooves 2111 as an example, the length of the first groove 2111 is set to $W1 \leq W < \lambda$. When $W < W1$, the length of the first groove 2111 is too small, thereby affecting the interception and reflection effect of the first groove 2111 on the surface acoustic wave. When $W > \lambda$, it may cause two adjacent first grooves 2111 arranged along the second direction to be communicated with each other, thereby increasing the resistance of the first bus bar 211, and affecting the use effect of the interdigital transducer.

In some exemplary embodiments, taking a plane parallel to the piezoelectric substrate 100 as a cross section, the cross section of each first groove 2111 is set to be one of a circle shape, an ellipse shape, a polygonal shape and an irregular shape; and the cross section of each second groove 2211 is set to be one of a circle shape, an ellipse shape, a polygonal shape and an irregular shape, where the irregular shape is formed by at least one straight line and at least one curve through enclosure.

With reference to FIG. 1, exemplarily, taking the plane parallel to the piezoelectric substrate 100 as a cross section, the cross section of the first groove 2111 is set to be a circle shape, and the cross section of the second groove 2211 is set to be a circle shape, with a diameter of the first groove 2111 being equal to the length of the first groove 2111 in the second direction, that is, the diameter of the first groove 2111 being equal to W.

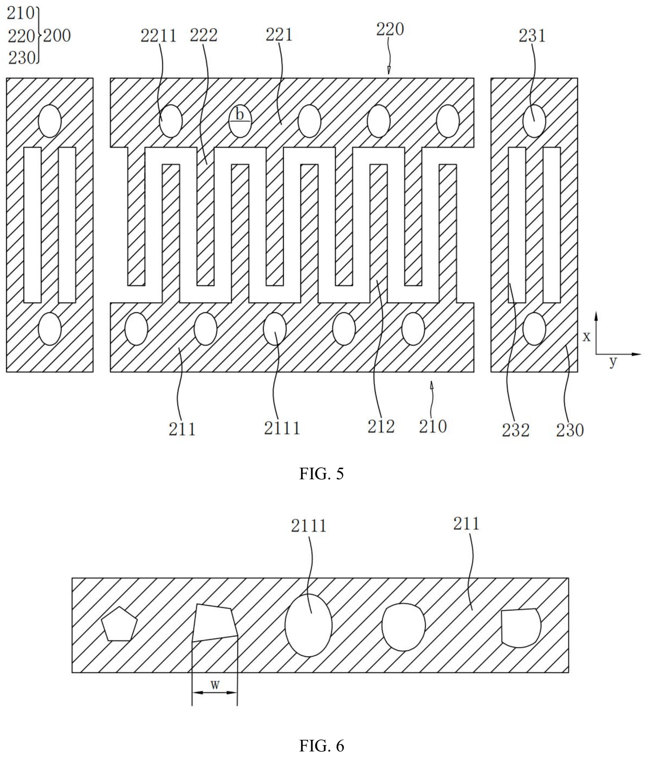

With reference to FIG. 5, alternatively, taking the plane parallel to the piezoelectric substrate 100 as a cross section, the cross section of the first groove 2111 is set to be an ellipse shape, with a major axis of the first groove 2111 being parallel to the first direction, or with the major axis of the first groove 2111 being parallel to the second direction; the cross section of the second groove 2211 is set to be an ellipse shape, with a major axis of the second groove 2211 being parallel to the first direction, or the major axis of the second groove 2211 being parallel to the second direction.

For example, the major axis of the first groove 2111 is parallel to the first direction, and the major axis of the second groove 2211 is parallel to the first direction. Taking the first groove 2111 as an example, a minor axis length of the first groove 2111 is equal to the length of the first groove 2111 in the second direction. The minor axis length of the first groove 2111 and the minor axis length of the second groove 2211 are both set as b, with the minor axis length b being configured as: $b \leq \lambda$. In addition, a major axis length of the first groove 2111 and a major axis length of the second groove 2211 are not further limited in the embodiments of the present application.

Exemplarily, in a thickness direction of the functional layer 200, the length of the first groove 2111 is equal to a thickness of the functional layer 200, and the length of the second groove 2211 is equal to the thickness of the functional layer 200, thereby ensuring the interception and reflection effects of the first groove 2111 and the second groove 2211 on surface acoustic wave.

With reference to FIG. 1 to FIG. 6, it is easily understood that, among the plurality of first grooves 2111, the shape of the cross section of at least one first groove 2111 is set to be the same as those of the cross sections of other first grooves 2111; or, the shape of the cross section of at least one first groove 2111 is set to be different from those of the cross sections of other first grooves 2111; and/or, among the plurality of second grooves 2211, the shape of the cross section of at least one second groove 2211 is set to be the same as those of the cross sections of other second grooves 2211, or, the shape of the cross section of at least one second groove 2211 is set to be different from those of the cross sections of other second grooves 2211.

Exemplarily, the cross section of the plurality of first grooves 2111 and the cross section of the plurality of second grooves 2211 may both be set to be circular; or, taking the first groove 2111 as an example, among plurality of first grooves 2111, the cross section of one first groove 2111 is set to be circular, the cross section of another first groove 2111 may be set to be elliptical, and the cross section of yet another first groove 2111 may also be set to be square-shaped.

In summary, the present application discloses an interdigital transducer, where the first bus bar 211 is provided with a plurality of first grooves 2111 arranged along the second direction, the second bus bar 221 is provided with a plurality of second grooves 2211 arranged along the second direction, the length W of the first groove 2111 is configured as: $W1 \leq W < \lambda$, and the length $W$ of the second groove 2211 is configured as: $W1 \leq W < \lambda$.

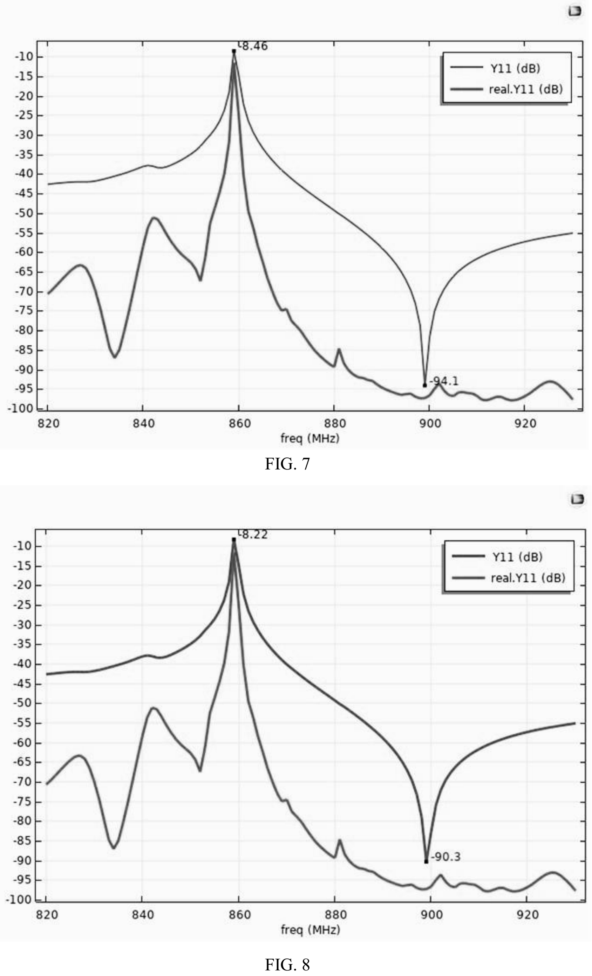

During the transmission of surface acoustic wave within the interdigital transducer, the surface acoustic wave propagates along the first direction towards a direction away from the second bus bar 221 when the surface acoustic wave is transmitted to an area between the first electrode finger 212 and the second bus bar 221; and the surface acoustic wave propagates along the first direction towards a direction away from the first bus bar 211 when the surface acoustic wave is transmitted to an area between the second electrode finger 222 and the first bus bar 211. The first groove 2111 and the second groove 2211 can play a certain role in intercepting the surface acoustic wave, so as to reduce the possibility of the surface acoustic wave escaping through the first bus bar 211 and the second bus bar 221, thereby reducing the possibility of the occurrence of scattering phenomenon in the interdigital transducer, and improving the quality factor of the surface acoustic wave. Referring to FIG. 7 and FIG. 8, where FIG. 7 is a simulation schematic diagram of the interdigital transducer in FIG. 1 provided by an embodiment of the present application, and FIG. 8 is a simulation schematic diagram of the interdigital transducer in FIG. 5 provided by an embodiment of the present application. As shown in the figures, the admittance curve (the curve located at the top) is smooth without burrs, especially in the area between Fs (the maximum value on the abscissa) and Fp (the minimum value on the abscissa) and its surrounding area, the admittance curve is very smooth, reflecting the excellent clutter suppression effect of the interdigital transducer. In addition, the curves near Fs and Fp are sharp, which reflects the characteristic of high quality factor of the resonator.

It is worth mentioning that, compared with the interdigital transducer in FIG. 5, the interdigital transducer in FIG. 1 has a curve which is sharper at Fp, thus having a higher quality factor at Fp.

The present application also discloses a resonator, including the interdigital transducer of any of the above implementations. The resonator may be configured as SAW resonator, temperature-compensated surface acoustic wave resonator, thin-film surface acoustic wave resonator, and the like.

Since the resonator includes the above-mentioned interdigital transducer, the resonator inherits all the advantages of the above-mentioned interdigital transducer. For details, please refer to the relevant description above, which will not be repeated here.

In the description of the present invention, it should be understood that, the orientations or positional relationships indicated by the terms "center", "longitudinal", "transverse", "length", "width", "thickness", "up", "down", "front", "back", "left", "right", "vertical", "horizontal", "top", "bottom", "inside", "outside" and the like are based on the orientations or positional relationships shown in the drawings, which are only for the convenience of describing the present invention and simplifying the description, rather than indicating or implying that the referred device or element must have a specific orientation, or be constructed and operated in a specific orientation, and therefore should not be understood as limitations on the present invention.

In the description of the present invention, it should be understood that, the terms "include" and "have" and any variations thereof used herein are intended to cover non-exclusive inclusions. For example, a process, method, system, product or device including a series of steps or units is not necessarily limited to those steps or units explicitly listed, but may include other steps or units not explicitly listed or inherent to such process, method, system, product or device.

Unless otherwise clearly specified and defined, the terms "install", "link", "connect", "fix", etc. should be understood in a broad sense. For example, it may be a fixed connection, a detachable connection, or an integrated formation; it may be a direct connection or an indirect connection through an intermediate medium, and it may be an internal connection between two elements or an interaction relationship between two elements. For those of ordinary skill in the art, the specific meanings of the above terms in the present invention may be understood according to the specific situations. In addition, the terms "first", "second", etc. are only used for descriptive purposes and should not be understood as indicating or implying relative importance or implicitly indicating the number of the indicated technical features.

Finally, it should be noted that each of the above embodiments is only used to illustrate the technical solutions of the present invention, rather than to limit it. Although the present invention has been described in detail with reference to the aforementioned embodiments, those skilled in the art should understand that they can still modify the technical solutions described in each of the aforementioned embodiments, or equivalently replace some or all of the technical features therein. However, these modifications or replacements do not make the essence of the corresponding technical solutions deviate from the scope of the technical solutions of each of the embodiments of the present invention.

## Claims

1. An interdigital transducer, comprising a piezoelectric substrate and a functional layer arranged on a surface of the piezoelectric substrate; wherein

   the functional layer comprises a first interdigital electrode and a second interdigital electrode, the first interdigital electrode comprises a first bus bar and a plurality of first electrode fingers arranged at intervals on the first bus bar, and the second interdigital electrode comprises a second bus bar and a plurality of second electrode fingers arranged at intervals on the second bus bar;
   the first bus bar and the second bus bar are arranged at intervals along a first direction, and both the first bus bar and the second bus bar extend along a second direction; the first electrode fingers are arranged on a side of the first bus bar close to the second bus bar, and one second electrode finger is accommodated between two adjacent first electrode fingers; and the second electrode fingers are arranged on a side of the second bus bar close to the first bus bar, and one first electrode finger is accommodated between two adjacent second electrode fingers;
   the first bus bar is provided with a first groove, and in the first direction, each of the second electrode fingers is arranged in correspondence to the first groove; and the second bus bar is provided with a second groove, and in the first direction, each of the first electrode fingers is arranged in correspondence to the second groove.

2. The interdigital transducer according to claim 1, wherein a plurality of first grooves are provided, and the plurality of the first grooves are arranged along the second direction, with a part of the plurality of the first grooves being arranged in correspondence to the second electrode fingers respectively; a plurality of second grooves are provided, and the plurality of the second grooves are arranged along the second direction, with a part of the plurality of the second grooves being arranged in correspondence to the first electrode fingers respectively.

3. The interdigital transducer according to claim 2, wherein a quantity of the first grooves is equal to a quantity of the second electrode fingers, and each of the first grooves is arranged in a one-to-one correspondence with each of the second electrode fingers;
   a quantity of the second grooves is equal to a quantity of the first electrode fingers, and each of the second grooves is arranged in the one-to-one correspondence with each of the first electrode fingers.

4. The interdigital transducer according to any one of claims 1 to 3, wherein along the second direction, a length of the first groove is greater than or equal to a width of the second electrode finger, and a length of the second groove is greater than or equal to a width of the first electrode finger.

5. The interdigital transducer according to claim 2, wherein taking a plane parallel to the piezoelectric substrate as a cross section, a shape of a cross section of each of the first grooves is one of circular shape, elliptical shape, polygonal shape or irregular shape, and a shape of a cross section of each of the second grooves is set to be one of circular shape, elliptical shape, polygonal shape and irregular shape; wherein the irregular shape is configured to be formed by at least one straight line and at least one curve through enclosure.

6. The interdigital transducer according to claim 5, wherein taking the plane parallel to the piezoelectric substrate as the cross section, the shape of the cross section of the first groove is the circular shape, and the shape of the cross section of the second groove is the circular shape.

7. The interdigital transducer according to claim 5, wherein taking the plane parallel to the piezoelectric substrate as the cross section, the shape of the cross section of the first groove is set to be the ellipse shape, and a major axis of the first groove is parallel to the first direction, or the major axis of the first groove is parallel to the second direction; the shape of the cross section of the second groove is set to be the ellipse shape, and a major axis of the second groove is parallel to the first direction, or the major axis of the second groove is parallel to the second direction.

8. The interdigital transducer according to claim 7, wherein the major axis of the first groove is parallel to the first direction, and the major axis of the second groove is parallel to the first direction;

a minor axis length of the first groove and a minor axis length of the second groove are both set as $b$, and the minor axis length $b$ is configured as:

$$b \leq \lambda;$$

wherein, $\lambda$ is set as a wavelength of surface acoustic wave, $\lambda=2\times(W1+W2)$, $W1$ is set as a width of the second electrode finger in the second direction, and $W2$ is set as a distance between the second electrode finger and adjacent first electrode finger in the second direction.

9. The interdigital transducer according to claim 5, wherein among the plurality of first grooves, a shape of a cross section of at least one of the first grooves is set to be the same as those of cross sections of others of the first grooves, or, a shape of a cross section of at least one of the first grooves is set to be different from those of cross sections of others of the first grooves; and/or, among the plurality of second grooves, a shape of a cross section of at least one of the second grooves is set to be the same as those of cross sections of others of the second grooves, or, a shape of a cross section of at least one of the second grooves is set to be different from those of cross sections of others of the second grooves.

10. The interdigital transducer according to claim 1, wherein in a thickness direction of the functional layer, a depth of the first groove is equal to a thickness of the functional layer, and a depth of the second groove is equal to the thickness of the functional layer.

11. The interdigital transducer according to claim 2, wherein in the second direction, a length of the first groove and a length of the second groove are both set as W; the length $W$ of the first groove is configured as: $W1 \leq W < \lambda$; wherein $W1$ is set as a width of the second electrode finger in the second direction; $\lambda$ is set as a wavelength of surface acoustic wave, with $\lambda=2\times(W1+W2)$, and $W2$ is set as a distance between the second electrode finger and adjacent first electrode finger in the second direction.

12. The interdigital transducer according to claim 2, wherein the first electrode finger is configured as a square-shaped first electrode finger, and the second electrode finger is configured as a square-shaped second electrode finger.

13. The interdigital transducer according to claim 12, wherein the square-shaped first electrode finger is provided with at least one first adjustment portion, and the at least one first adjustment portion is arranged along the first direction; the square-shaped second electrode finger is provided with at least one second adjustment portion, and the at least one second adjustment portion is arranged along the first direction.

14. The interdigital transducer according to claim 13, wherein the first adjustment portion is set as an arc-shaped first adjustment portion, a square-shaped first adjustment portion, and an irregular-shaped first adjustment portion, and in a plane where the functional layer is located, the irregular-shaped first adjustment portion is formed by at least one straight line and at least one curve through enclosure; the second adjustment portion is set as an arc-shaped second adjustment portion, a square-shaped second adjustment portion, and a special-shaped second adjustment portion, and in the plane where the functional layer is located, the irregular-shaped second adjustment portion is formed by at least one straight line and at least one curve through enclosure.

15. The interdigital transducer according to claim 14, wherein the first adjusting portion is set as the arc-shaped first adjusting portion, and on the square-shaped first electrode finger, the arc-shaped first adjusting portion protrudes toward the second direction;
the second adjusting portion is set as the arc-shaped second adjusting portion, and on the square-shaped second electrode finger, the arc-shaped second adjusting portion protrudes toward the second direction.

16. The interdigital transducer according to claim 14, wherein each square-shaped first electrode finger is provided with two first adjustment portions, and one of the first adjustment portions is arranged at one end of the square-shaped first electrode finger away from corresponding first bus bar, and the other first adjustment portion is arranged at one end of the square-shaped first electrode finger close to corresponding first bus bar;
each square-shaped second electrode finger is provided with two second adjustment portions, and one of the second adjustment portions is arranged at one end of the square-shaped second electrode finger away from corresponding second bus bar, and the other second adjustment portion is arranged at one end of the square-shaped second electrode finger close to corresponding second bus bar.

17. The interdigital transducer according to claim 16, wherein a plurality of first adjustment portions and a plurality of second adjustment portions are arranged along the second direction.

18. The interdigital transducer according to claim 13, wherein in the second direction, a width of the first adjustment portion is smaller than a length of the first groove; and a width of the second adjustment portion is smaller than a length of the second groove.

19. The interdigital transducer according to claim 1, wherein a distance between one end of the first electrode finger away from the first bus bar and the second bus bar is less than or equal to $1.5\lambda$; and a distance between one end of the second electrode finger away from the second bus bar and the first bus bar is less than or equal to $1.5\lambda$; wherein, $\lambda$ is set as a wavelength of surface acoustic wave, $\lambda=2\times(W1+W2)$, $W1$ is set as a width of the second electrode finger in the second direction, and $W2$ is set as a distance between the second electrode finger and adjacent first electrode finger in the second direction.

20. The interdigital transducer according to claim 1, wherein the first bus bar is provided with a plurality of first dummy fingers, and in the first direction, each first dummy finger is arranged in correspondence to one second electrode finger;
the second bus bar is provided with a plurality of second dummy fingers, and in the first direction, each second dummy finger is arranged in correspondence to one first electrode finger.

21. The interdigital transducer according to claim 20, wherein in the first direction, a distance between the each first dummy finger and corresponding second electrode finger is set to be less than or equal to $\lambda$; and a distance between the each second dummy finger and corresponding first electrode finger is set to be less than or equal to $\lambda$; wherein, $\lambda$ is set as a wavelength of surface acoustic wave, $\lambda=2\times(W1+W2)$, $W1$ is set as a width of the second electrode finger in the second direction, and $W2$ is set as a distance between the second electrode finger and adjacent first electrode finger in the second direction.

22. The interdigital transducer according to claim 1, wherein the piezoelectric substrate is configured as a single-layer piezoelectric substrate, or the piezoelectric substrate is configured as a multi-layer piezoelectric substrate.

23. The interdigital transducer according to claim 22, wherein the piezoelectric substrate is configured as the multi-layer piezoelectric substrate, and the multi-layer piezoelectric substrate comprises a base body and a piezoelectric film arranged on a surface of the base body, with the piezoelectric film being connected to the functional layer.

24. The interdigital transducer according to claim 23, wherein the base body is made of one of sapphire, spinel, quartz and ceramic;
the piezoelectric film is made of one of lithium tantalate, lithium niobate, aluminum nitride and zinc oxide.

25. The interdigital transducer according to claim 1, wherein the first interdigital electrode is configured as a single-layer first interdigital electrode, or the first interdigital electrode is configured as a multi-layer first interdigital electrode;
the second interdigital electrode is configured as a single-layer second interdigital electrode, or the second interdigital electrode is configured as a multi-layer second interdigital electrode.

26. The interdigital transducer according to claim 1, wherein the first interdigital electrode and the second interdigital electrode are made of one or more of aluminum, copper, gold, silver, chromium, titanium, tungsten, and alloy materials.

27. The interdigital transducer according to claim 1, wherein the functional layer further comprises two reflective structures, and the two reflective structures are respectively arranged on two ends of the first bus bar along the second direction;
in the first direction, one end of reflective structure is flush with the first bus bar, and the other end of the reflective structure is flush with the second bus bar.

28. The interdigital transducer according to claim 27, wherein the reflective structure is provided with two grooves, and in the second direction, one of the two grooves is flush with the first groove, and the other of the two grooves is flush with the second groove.

29. The interdigital transducer according to claim 27, wherein the reflective structure is further provided with a plurality of elongated holes, and the plurality of elongated holes are arranged along the second direction, and the elongated holes extend along the first direction.

30. The interdigital transducer according to claim 1, wherein the functional layer is configured as: forming a functional layer base on the surface of the piezoelectric substrate, and removing a portion of the functional layer base, so as to form the functional layer with the remaining functional layer base.

31. The interdigital transducer according to claim 1, wherein that the functional layer is configured as: covering the surface of the piezoelectric substrate with a shielding layer which is provided with openings corresponding to the first interdigital electrode and the second interdigital electrode; and forming the first interdigital electrode and the second interdigital electrode in the openings, so as to form the functional layer with the first interdigital electrode and the second interdigital electrode.

32. A resonator, comprising the interdigital transducer according to any one of claims 1 to 31.

210⎫
220⎬200
230⎭

2211  222  221  A  220  231

W1

W2

w

211  2111  212  210  232  230

x
y

FIG. 1

A — A

211  2111  222  221

100

FIG. 2

FIG. 3

FIG. 4

FIG. 5

FIG. 6

FIG. 7

FIG. 8

## INTERNATIONAL SEARCH REPORT

| International application No. |
| --- |
| **PCT/CN2023/077977** |

**A.    CLASSIFICATION OF SUBJECT MATTER**

H03H9/145(2006.01)i

According to International Patent Classification (IPC) or to both national classification and IPC

**B.    FIELDS SEARCHED**

Minimum documentation searched (classification system followed by classification symbols)

IPC:H03H

Documentation searched other than minimum documentation to the extent that such documents are included in the fields searched

Electronic data base consulted during the international search (name of data base and, where practicable, search terms used)

CNABS; CNTXT; USTXT; WOTXT; EPTXT; DWPI; VEN; CNKI; IEEE: 叉指换能器, 汇流条, 电极, 凹槽, 孔, 洞, 开口, interdigital transducer, IDT, busbar, electrode, groove, hole, cave, opening

**C.    DOCUMENTS CONSIDERED TO BE RELEVANT**

| Category* | Citation of document, with indication, where appropriate, of the relevant passages | Relevant to claim No. |
| --- | --- | --- |
| X | CN 114430886 A (MURATA MANUFACTURING CO., LTD.) 03 May 2022 (2022-05-03) description, paragraphs 11-109, and figures 1-2 | 1-32 |
| X | CN 107534428 A (MURATA MANUFACTURING CO., LTD.) 02 January 2018 (2018-01-02) description, paragraphs 6-73, and figures 1-5 | 1-32 |
| X | CN 213937859 U (MURATA MANUFACTURING CO., LTD.) 10 August 2021 (2021-08-10) description, paragraphs 91-152, and figures 5 and 17-20 | 1-32 |
| X | CN 105284047 A (MURATA MANUFACTURING CO., LTD.) 27 January 2016 (2016-01-27) description, paragraphs 11-99, and figures 1-14 | 1-32 |
| A | JP 2019106607 A (SEIKO EPSON CORP.) 27 June 2019 (2019-06-27) entire document | 1-32 |

☐ Further documents are listed in the continuation of Box C.        ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **16 September 2023** | **20 September 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/077977**

| Patent document cited in search report | | | Publication date (day/month/year) | Patent family member(s) | | | Publication date (day/month/year) |
|---|---|---|---|---|---|---|---|
| CN | 114430886 | A | 03 May 2022 | US | 2022224311 | A1 | 14 July 2022 |
| | | | | WO | 2021065684 | A1 | 08 April 2021 |
| | | | | KR | 20220047350 | A | 15 April 2022 |
| CN | 107534428 | A | 02 January 2018 | DE | 112016001894 | T5 | 04 January 2018 |
| | | | | DE | 112016001894 | B4 | 03 February 2022 |
| | | | | WO | 2016170982 | A1 | 27 October 2016 |
| | | | | JPWO | 2016170982 | A1 | 18 May 2017 |
| | | | | JP | 6245378 | B2 | 13 December 2017 |
| | | | | US | 2018062612 | A1 | 01 March 2018 |
| | | | | US | 10840878 | B2 | 17 November 2020 |
| | | | | CN | 107534428 | B | 18 December 2020 |
| | | | | US | 2021036681 | A1 | 04 February 2021 |
| CN | 213937859 | U | 10 August 2021 | JP | 2021077956 | A | 20 May 2021 |
| CN | 105284047 | A | 27 January 2016 | WO | 2014192756 | A1 | 04 December 2014 |
| | | | | KR | 20150144799 | A | 28 December 2015 |
| | | | | KR | 101690492 | B1 | 28 December 2016 |
| | | | | US | 2016072475 | A1 | 10 March 2016 |
| | | | | US | 10009009 | B2 | 26 June 2018 |
| | | | | JPWO | 2014192756 | A1 | 23 February 2017 |
| | | | | JP | 6179594 | B2 | 16 August 2017 |
| | | | | CN | 105284047 | B | 12 October 2018 |
| JP | 2019106607 | A | 27 June 2019 | None | | | |

Form PCT/ISA/210 (patent family annex) (July 2022)

**REFERENCES CITED IN THE DESCRIPTION**

**Patent documents cited in the description**

- CN 202310120451